# EUROPEAN PATENT APPLICATION

(11) **EP 1 583 069 A2**
(43) Date of publication of application: **05.10.2005**
(21) Application number: 04025093.8
(22) Date of filing: 21.10.2004
(51) Int. Cl.: G09G 3/34, G09G 3/36, G03F 7/20

(54) **Spatial light modulator and method of performing photolithography using the same**

(30) Priority: 26.03.2004 US 811407
(71) Applicant: Agilent Technologies, Inc., Palo Alto, CA 94306 (US)
(72) Inventor: Schroeder, Dale W., Scotts Valley, CA 95066 (US)
(74) Representative: Liesegang, Roland

(57) **Abstract**

An electronic circuit that can be used, for example, in a spatial light modulator (110) to photolithographically transfer an image onto a substrate (150), includes a strobe line (800) electrically coupled to a set of circuit elements (310) within an array (300) of circuit elements (310). The circuit elements (310) are alterable in response to data (222) stored therein, and the set of circuit elements (310) includes row-adjacent and column-adjacent ones of the circuit elements (310). The strobe line (800) provides a strobe signal (602) to the circuit elements (310) in the set to cause the circuit elements (310) in the set to shift the data (222) to non-adjacent ones of the circuit elements (310) outside the set in an interleaving pattern.

## Description

### CROSS-REFERENCE TO RELATED APPLICATIONS

This application is related by subject matter to U.S. Utility Applications for Patent Attorney Docket No. 10030517, entitled ANGLED STROBE LINES FOR HIGH ASPECT RATIO SPATIAL LIGHT MODULATOR; and docket No. 10030929, entitled BUFFERS FOR INTERLEAVED LIGHT MODULATION ELEMENTS IN SPATIAL LIGHT MODULATORS, each filed on an even date herewith.

### BACKGROUND OF THE INVENTION

### Technical Field of the Invention

The present invention relates generally to photolithography, and more specifically, to dynamic photolithography systems.

### Description of Related Art

Recently, dynamic photolithography systems have been developed that employ a spatial light modulator (SLM) to define a pattern that is imaged onto a substrate having a photosensitive surface, such as a layer of photoresist. SLMs are electrical devices that include an array of individually controllable light modulation elements (e.g., liquid crystal cells or micromirrors) that define pixels of an image in response to electrical signals. Typically, at small feature sizes (e.g., 5 µm or smaller), there are tens of millions of light modulation elements within an SLM that is not more than a few square centimeters in area. For example, an SLM including an array of 16,384 columns by 606 rows of 3 µm light modulation elements has been proposed for use in transferring such small feature sizes.

With the small SLM size, multiple exposures are generally required to image the entire area of the substrate. Since the image formed by the SLM is easily reconfigurable, it is a relatively simple process to divide the final image into sections, configure the SLM to transfer one of the image sections onto the appropriate area of the substrate surface, shift the relative position of the substrate and SLM and repeat the process for each image section until the entire image is transferred onto the substrate surface.

However, with the large number of light modulation elements, it is impracticable to assume that the SLM will be free from defects. Statistically, there will be at least a few of the tens of millions of light modulation elements of the SLM that are defective. As a result of the multiple imaging process, each defective light modulation element produces N pixel defects on the substrate surface, where N is the number of sections the image is divided into. To limit the number of defects in the transferred image caused by defective light modulation elements, the data can be shifted through the SLM to transfer each image section onto the same portion of the substrate multiple times using different light modulation elements in the SLM, as described in co-pending and commonly assigned U.S. Application for Patent Serial No. (Attorney Docket No. 10030571).

Strobe lines within the SLM provide strobe signals to the light modulation elements to drive the data shifting between the light modulation elements in a shift register configuration. However, to shift the data through the SLM requires one clock cycle for each position shifted. For example, a 600 pixel long shift register chain requires 600 clock cycles to shift the data from input to output. The time necessary for 600 clock cycles may be greater than the time available between image transfers. In addition, with a shift register configuration, a defect at one point in the shift register chain propagates from the defect point to the end of the chain.

Therefore, what is needed is a strobe line configuration to decrease the number of clock cycles necessary to shift data through the SLM and reduce the effect of a propagation error in a shift register chain.

### SUMMARY OF THE INVENTION

Embodiments of the present invention provide an electronic circuit that can be used in a spatial light modulator, for example. The electronic circuit includes circuit elements arranged in an array of rows and columns. The circuit elements are alterable in response to data stored therein, and are configured to shift data between the circuit elements. A strobe line is electrically coupled to a set of the circuit elements. The set includes row-adjacent and column-adjacent ones of the circuit elements. The strobe line provides to the circuit elements in the set a strobe signal that causes the circuit elements in the set to shift the data to non-adjacent circuit elements outside of the set in an interleaving pattern.

In one embodiment, the strobe line is electrically coupled to circuit elements in at least a portion of at least two adjacent rows or columns in the array to provide a strobe signal to the circuit elements to shift the data between non-adjacent rows or columns, respectively, of the circuit elements. In another embodiment, the strobe line is electrically coupled to at least two groups of circuit elements positioned diagonally in the array with respect to one another. Each group includes circuit elements in at least a portion of two or more adjacent rows or columns in the array.

In a further embodiment, at least one is buffer is connected an end of the array to load data into a portion of the array. The buffer is configured to load data into at least a portion of at least two rows or columns of circuit elements. In one embodiment, the buffer includes buffer elements, each loading data into a respective portion of the array. A first strobe line associated with a second portion of the array is configured to clock a first buffer associated with a first portion of the array to load data into the first portion of the array. A shift register is electrically connected to the strobe lines to sequentially apply the strobe signal to the strobe lines.

Other embodiments of the present invention provide a process for performing photolithography in which data representing an image is loaded into light modulation elements. Certain ones of the light modulation elements are altered in response to the data loaded into the light modulation elements to transfer an instance of the image onto a substrate. The data is shifted between non-adjacent light modulation elements in an interleaving pattern. Additional ones of the light modulation elements are altered in response to the shifted data to transfer another instance the image onto the substrate.

By shifting the data in an interleaving pattern throughout the array of light modulation elements, the number of clock cycles necessary to shift the data through the array is reduced. In addition, interleaving the data reduces the effect of a propagation error in the shift register chain. Furthermore, the invention provides embodiments with other features and advantages in addition to or in lieu of those discussed above. Many of these features and advantages are apparent from the description below with reference to the following drawings.

### BRIEF DESCRIPTION OF THE DRAWINGS

The disclosed invention will be described with reference to the accompanying drawings, which show sample embodiments of the invention and which are incorporated in the specification hereof by reference, wherein:
FIG. 1 illustrates a photolithography system utilizing a spatial light modulator to photolithographically transfer an image to a substrate in accordance with embodiments of the present invention;
FIG. 2 is a block diagram illustrating a computing system operable to control the photolithography system of FIG. 1;
FIG. 3 is a circuit schematic of an exemplary spatial light modulator for shifting data through the spatial light modulator, in accordance with embodiments of the present invention;
FIG. 4 is a representation of an exemplary shift register configuration of light modulation elements within the spatial light modulator of FIG. 3;
FIG. 5 is a block diagram of an exemplary spatial light modulator for loading data into the light modulation elements;
FIG. 6 is a timing diagram for shifting data between the light modulation elements;
FIG. 7 illustrates an exemplary substrate exposure timing sequence;
FIG. 8 illustrates an exemplary spatial light modulator including a strobe line configuration for interleaving data between light modulation elements, in accordance with embodiments of the present invention;
FIG. 9 illustrates an exemplary data interleaving configuration between light modulation elements, in accordance with embodiments of the present invention;
FIG. 10 illustrates a logical interleaved association between pixel controllers and memory elements within respective light modulation elements of a spatial light modulator, in accordance with embodiments of the present invention;
FIG. 11 is an exemplary circuit schematic of a spatial light modulator for shifting data between memory elements of non-adjacent light modulation elements in an interleaving pattern, in accordance with embodiments of the present invention;
FIG. 12A illustrates an exemplary spatial light modulator including a shortened strobe line configuration for interleaving data between light modulation elements in accordance with other embodiments of the present invention;
FIG. 12B illustrates an exemplary spatial light modulator including a strobe line configuration for clocking the buffers to load data into the light modulation elements;
FIG. 13 is a flow chart illustrating an exemplary process to provide strobe signals to light modulation elements within a spatial light modulator to shift data between light modulation elements; and
FIG. 14 is a flow chart illustrating an exemplary process for shifting data within a spatial light modulator to dynamically photolithographically transfer an image onto a substrate.

### DETAILED DESCRIPTION OF EXEMPLARY EMBODIMENTS

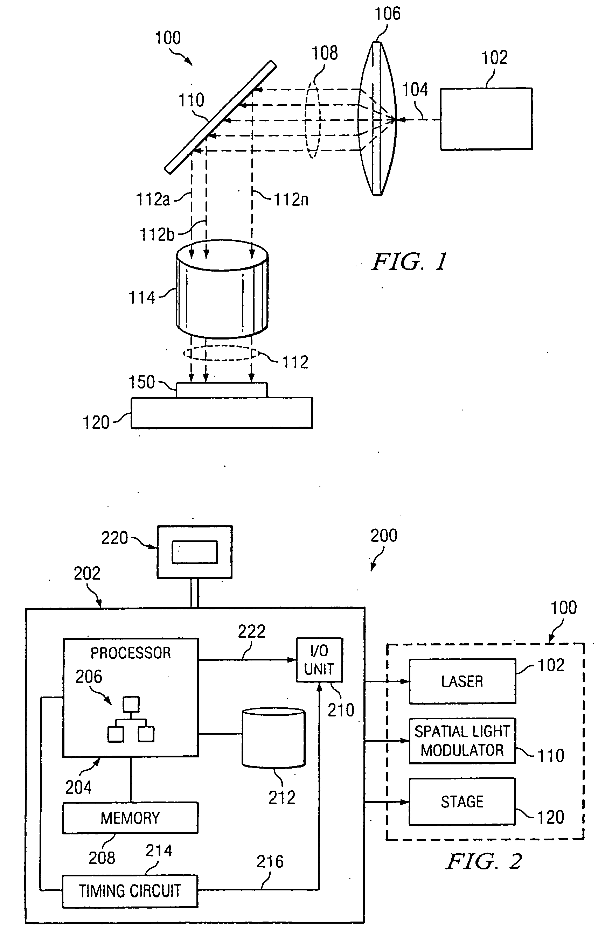

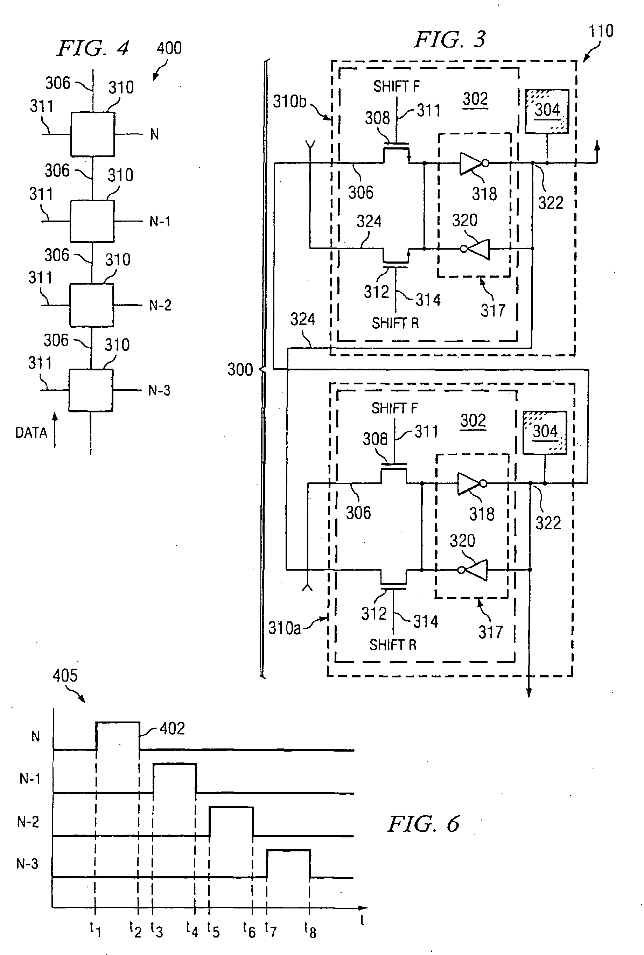

FIG. 1 illustrates a dynamic photolithography system 100 for photolithographically transferring an image to a substrate 150. The photolithography system 100 includes a light source 102 operable to output light 104. The light source 102 can be a laser, such as an excimer laser, or other non-laser source, as understood in the art. The light source 102 is optically coupled to beam shaping optics 106. The output of the beam shaping optics 106 is light 108 that is directed toward a spatial light modulator 110 in accordance with embodiments of the present invention. The spatial light modulator 110 includes light modulation elements (not shown) operable to selectively transfer the light 108. The light modulation elements are described in more detail below in connection with FIG. 3. In one embodiment, the light modulation elements are liquid crystal elements. However, it should be understood that in other embodiments, the light modulation elements are micromirrors or another type of optical device that can selectively transfer light by reflection, transmission or otherwise.

The output of the spatial light modulator 110 includes dark areas with no light and light areas made up of multiple light beams 112a - 112n (collectively 112) that are transferred by selected light modulation elements to form at least a portion of an image containing a pattern. The light beams 112 are directed to projection optics 114, which is optically aligned to direct the light beams 112 onto the substrate 150. A photosensitive layer (not shown), such as a layer of photoresist, is on the surface of the substrate 150. The photosensitive layer reacts in response to the light beams 112 to produce the pattern on the surface of the substrate 150. In one embodiment, the substrate 150 is mounted on a scanning stage 120 to move the substrate 150 in any direction relative to the spatial light modulator 110. The scanning stage 120 can be, for example, a high precision scanning stage. In another embodiment, the substrate 150 remains stationary and the optics and/or light beams 112 move relative to the substrate 150. In either configuration, one of the substrate 150 and the spatial light modulator 110 is moved relative to the other to transfer the image onto the substrate 150.

The spatial light modulator 110 further includes pixel drive circuits (not shown) that are uniquely coupled to the light modulation elements. The pixel drive circuits are described in more detail below in connection with FIG. 3. The pixel drive circuits store data that define the state of the light modulation elements. For example, light modulation elements that are reflective can be selectively altered to be in a reflective or non-reflective state such that the received light 108 is either reflected or not reflected onto the substrate 150 by storing data (e.g., logical LOW and HIGH data values) in pixel drive circuits associated with the light modulation elements. In effect, the spatial light modulator 110 operates as a dynamic mask that forms a pattern that is imaged onto the photosensitive layer of the substrate 150.

FIG. 2 is a block diagram illustrating the configuration 200 of a computing system 202 operable to control the photolithography system 100 of FIG. 1. The computing system 202 includes a processing unit 204 operable to execute software 206. The processing unit 204 can be any type of microprocessor, microcontroller, programmable logic device, digital signal processor or other processing device. The processing unit 204 is coupled to a memory unit 208 and input/output (I/O) unit 210. The I/O unit 210 can be wired or wireless. The processing unit 204 is further coupled to a storage unit 212 that stores the image to be transferred and timing circuit 214 that generates timing signals 216 for the photolithography system 100. An electronic display 220 is optionally coupled to the computing system 202 and operable to display an image (or portion of an image) that is to be communicated to the spatial light modulator 110 for imaging onto the substrate 150 of FIG. 1.

The timing signals 216 control the operation of the stage 120, spatial light modulator 110 and laser 102 during exposure cycles. Examples of timing signals 216 include data clock signals to sequentially clock data 222 representing a portion of an image into the spatial light modulator 110, strobe signals provided along strobe lines within the spatial light modulator 110 to shift data between light modulation elements of the spatial light modulator 110, exposure signals to initiate a flash of the laser 102, and other clock signals to drive the spatial light modulator 110, laser 102 and stage 120. The processor 204 communicates with the timing circuit 214 and I/O unit 210 to communicate the data 222 and timing signals 216 to the spatial light modulator 110 and other components of the photolithography system 100, such as the laser 102 and stage 120. For example, during an exposure cycle, data 222 is shifted between light modulation elements within the spatial light modulator 110 by strobe signals, data 222 is transmitted from the computing system 202 to the spatial light modulator 110 in response to a data clock signal and the other clock signals drive the SLM 110, stage 120 and laser 102 to alter the state of light modulation elements within the SLM 110 as a function of the data 222, to align the stage 120 with the SLM 110 for image transfer and to control the timing of the exposure signal to initiate the laser 102 flash.

To reduce defects in the transferred image due to light modulation element defects, the data 222 communicated to the SLM 110 during each exposure cycle includes only a portion of the image to enable optical oversampling of the image on the substrate. An example of an optical oversampling technique is described in co-pending and commonly assigned U.S. Applications for Patent Serial Nos. (Attorney Docket No. 10030571) and (Attorney Docket No. 10040070), which are incorporated by reference herein.

In one embodiment, the image is divided into sections, with each section transferred by the SLM 110 during a single exposure cycle. In addition, each section is divided into subsections, such that the data 222 sent to the SLM 110 represents at least one of the image subsections. The data representing the remaining image subsections of a particular image section are shifted within the SLM 110 to enable the remaining image subsections to be imaged by different light modulation elements of the SLM 110.

For example, in one implementation embodiment, if each image section is divided into six image subsections, the data 222 includes data previously transferred to the substrate that represents five image subsections and data representing one new image subsection. However, with potentially tens of millions of light modulation elements, writing the data 222 representing all of the image subsections to the SLM 110 during each exposure cycle requires a large amount of data 222 to be communicated between the I/O unit 602 and the SLM 110. Such a large I/O bandwidth increases the power consumption and limits the throughput speed of photolithography systems 100. Therefore, in other implementation embodiments, the data 222 communicated to the SLM 110 during each exposure cycle includes only that representing the new image subsection(s) and not that representing any of the previously transferred image subsections in order to reduce bandwidth, thereby reducing power consumption and increasing throughput speed. The data representing the image subsections previously transferred to the substrate are stored within the SLM 110 and moved internally within the SLM 110.

FIG. 3 is a schematic of a portion of an exemplary spatial light modulator 110 capable of moving data internally during a photolithographic process. The SLM includes an array 300 of circuit elements, hereinafter referred to as light modulation elements 310a and 310b (collectively 310), each including a memory element 302 in communication with an associated pixel controller 304 that is at least partially responsible for controlling the state of a pixel defined by the light modulation element 310. In FIG. 3, each memory element 302 is a static memory element that includes an input line 306 and a forward access control element 308. In the example shown, the forward access control element 308 is a transistor having a forward access strobe line 311 that is operable to control the state of the forward access control element 308 during a shift forward operation. In FIG. 3, a shift forward operation shifts data up from light modulation element 310a to light modulation element 310b. Each memory element 302 further includes a reverse access control element 312 having a reverse access strobe line 314 operable to control the state of the reverse access control element 312 during a shift reverse operation. In FIG. 3, a shift reverse operation shifts data down from light modulation element 310b to light modulation element 310a.

Depending on the configuration of the array 300, light modulation elements 310a and 310b are either positioned in different columns of the same row or in different rows of the same column, as shown in FIG. 3. Thus, the memory elements 302 are configured to shift data bi-directionally between adjacent rows or columns of the array 300. In addition, it should be understood that in other embodiments, the memory elements 302 can additionally or alternatively be configured to shift the data between non-adjacent rows, columns or light modulation elements 310 of the array 300.

A common node 316 of the forward and reverse access control elements 308 and 312, respectively, is coupled to a memory cell 317. In one embodiment, the memory cell 317 is a bi-stable circuit or static latch utilized to store data representing one pixel of the image. The memory cell 317 is shown implemented as a latch (i.e., a switch and back-to-back inverters) that uses a ripple clock to propagate data between memory cells 317. The ripple clock is described in more detail below with reference to FIGs. 4-7.

Each memory cell 317 includes a forward inverter 318 and a feedback inverter 320. The feedback inverter 320 is a "weak" feedback element that is utilized to reinforce the current state (i.e., LOW or HIGH state) to a stable position. Thus, if the common node 316 is in a low voltage level (i.e., a LOW state), the forward inverter 318 inverts the LOW state to a HIGH state on the output coupled to output node 322. The HIGH state on output node 322 is an input to the feedback inverter 320, which outputs a low voltage level onto node 316. The low voltage level output from the weak feedback inverter 320 reinforces, but does not control, the LOW state on node 316. Similarly, a high voltage level output from the weak feedback inverter 320 reinforces, but does not control, the HIGH state on node 316.

The output node 322 is coupled to the pixel controller 304 and is also the output node of the light modulation element 310. In one embodiment, the pixel controller 304 is a pixel electrode of a liquid crystal (LC) light modulation element. The voltage level on output node 322 is applied to the pixel electrode of the LC light modulation element to alter the state of the LC light modulation element when the voltage level applied to the pixel electrode differs from a voltage applied to a common electrode of the LC light modulation element. In other embodiments, the pixel controller 304 is an electromechanical device controlling the state or position of a micromirror.

Multiple light modulation elements 310 are electrically interconnected. In one embodiment, the light modulation elements 310 are connected in a shift register configuration, as shown in FIG. 3. In the shift register configuration, the output node 322 of a first light modulation element (e.g., light modulation element 310a) is connected to the input line 306 of a second light modulation element (e.g., light modulation element 310b). The output node 322 of the second light modulation element 310b is connected to the input line of a third light modulation element (not shown), and so on until the output node of the (N-1)th pixel (not shown) is connected to the input line 306 of the Nth pixel (not shown), thereby forming a forward connection network. To load input data into the forward connection network, the input data is provided at the input line 306 of the first light modulation element 310a, and data is shifted from the first light modulation element 310a to the second light modulation element 310b when a strobe signal is received on forward access strobe line 311 of light modulation element 310a, and so on. It should be understood that a similar data loading and shifting configuration can be implemented for a reverse connection network, where data is input to the last light modulation element 310 in the array 300.

FIG. 4 is a block diagram of an exemplary high-level shift register configuration 400 of the light modulation elements 310. The light modulation elements 310 have forward access strobe lines 311 coupled thereto for causing data on the input lines 306 to propagate through the memory elements 302 (shown in FIG. 3) in the forward direction. The light modulation elements 310 can be viewed as elements N, N-1, N-2, N-3, and so forth, where the Nth light modulation element 310 is the last light modulation element and the (N-3)rd light modulation element 310 is the first light modulation element. The shift register configuration 400 can cause data to propagate between adjacent and/or non-adjacent rows and/or columns of an array of light modulation elements 310.

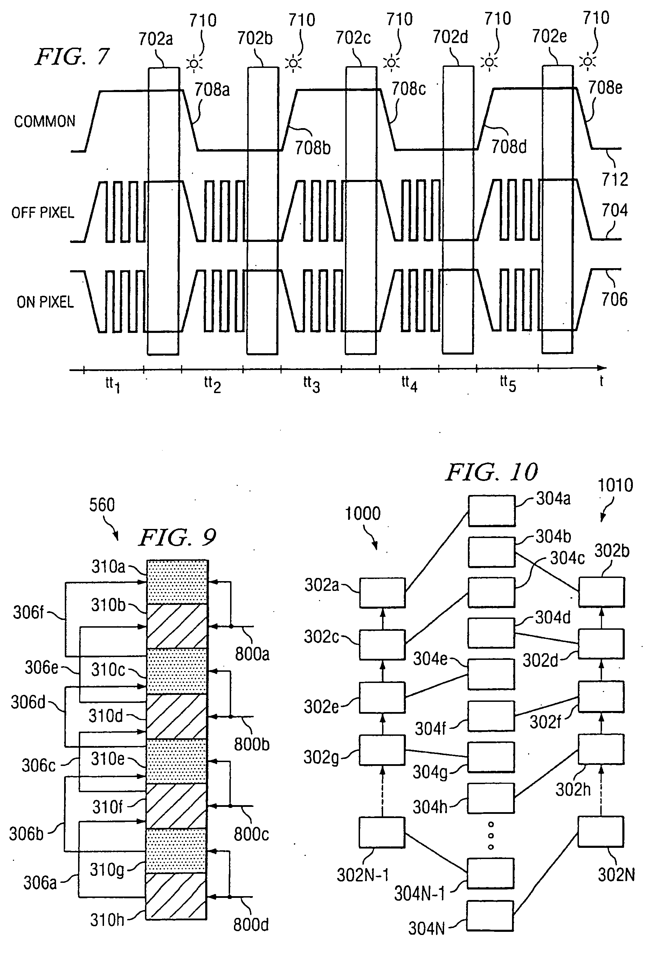

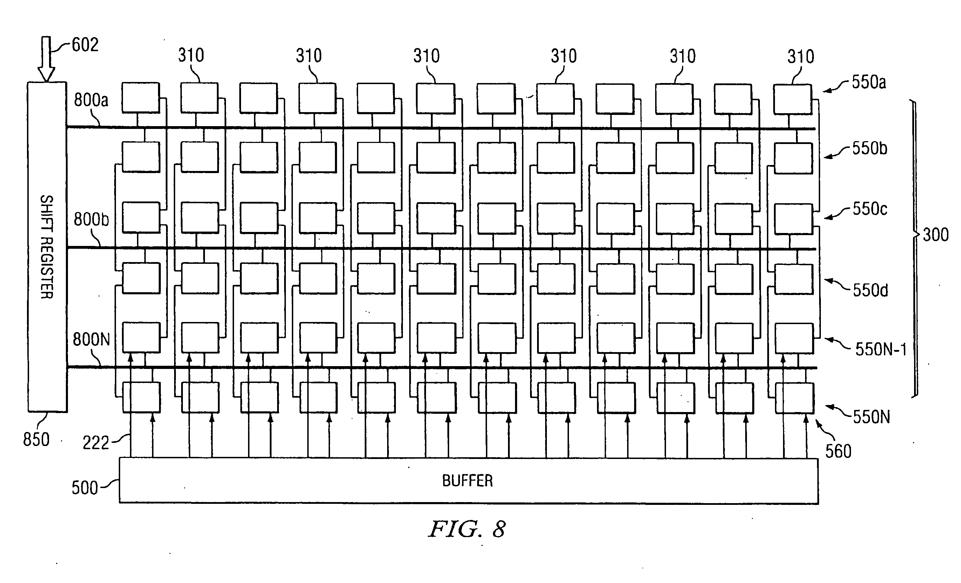

FIG. 6 is a timing diagram 605 for shifting data between the light modulation elements. As shown in FIG. 6, a sequence of non-overlapping strobe signals, produced by a ripple clock or otherwise, is utilized to shift the data through the light modulation elements. As shown, a strobe signal 602 is applied to the forward access control element 308 of the Nth light modulation element via forward access strobe line 311 between times t₁ and t₂ to move data out of the Nth light modulation element. Each of the other strobe signals 602 for the memory elements of the (N-1)th, (N-2)th and (N-3)th light modulation elements are pulsed sequentially such that the data is moved serially from the (N-1)th light modulation element to the Nth light modulation element between times t₃ and t₄, from the (N-2)th light modulation element to the (N-1)th light modulation element between times t₅ and t₆ and from the (N-3) the light modulation element to the (N-2)th light modulation element between times t₇ and t₈ so as to ensure the data is preserved as it is shifted through the light modulation elements. It should be understood that a similar shifting mechanism can be used to shift data in a reverse sequence to enable bi-directional data movement.

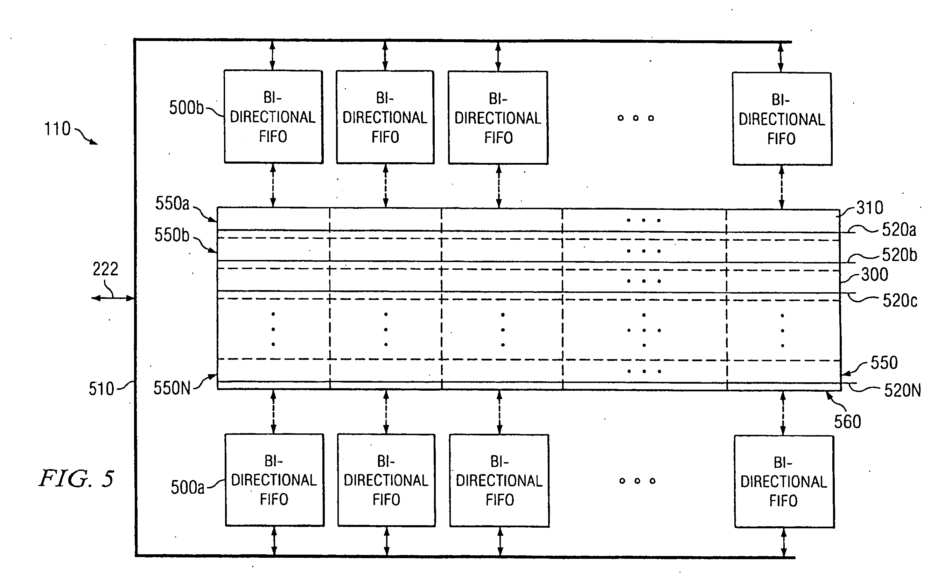

FIG. 5 is a block diagram of an exemplary configuration of the spatial light modulator 110 of FIG. 3 with the light modulation elements 310 arranged in a shift register configuration similar to that shown in FIG 4. The array 300 of light modulation elements 310 is shown arranged in rows 550 and columns 560. There are more columns 560 than rows 550, resulting in a spatial light modulator 110 with a high aspect ratio. In the example shown in FIG. 5, the light modulation elements 310 are configured to shift data between rows 550 of the array 300. However, it should be understood that in other embodiments, the light modulation elements can be configured to shift data between columns 560 of the array 300.

In one embodiment, strobe lines 520a, 520b...520N connected to forward access strobe lines 311 (shown in FIG. 3) of individual light modulation elements 310 run the length of the rows 550 to shift data between the rows 550. Thus, as a strobe signal is sent down each of the strobe lines, the data is shifted between rows 550. For example, assuming the data is shifted up in the array 300, at an initial time (e.g., t₁) a first strobe signal is sent down the strobe line 520a on row 550a of light modulation elements 310 to shift the data in row 550a of light modulation elements 310 out of the array 300. At a subsequent time (e.g., t₂), a second strobe signal is sent down the strobe line 520b on row 550b of the array 300 to shift the data from the light modulation elements 310 in row 550b to the light modulation elements 310 in row 550a. This process is continued until a strobe signal is sent down the strobe line 520N on row 550N of the array 300 to shift up the data in row 550N of light modulation elements 310.

In other embodiments, data 222 is input to the light modulation elements 310 via bus 510 and buffers 500a and 500b (collectively 500). Each data buffer 500 is a bi-directional first-in-first-out (FIFO) buffer that stores and loads data 222 into the light modulation elements 310 associated with the data buffer 500. In one embodiment, each data buffer 500 loads data 222 into a single column 560 of the array 300. In another preferred embodiment, each data buffer 500 loads data 222 into multiple columns 560 of the array 300. For example, after the data in the light modulation elements 310 in row 550N is shifted up, new data 222 is loaded into row 550N of light modulation elements 310 from buffers 500a. The data 222 output from the light modulation elements 310 in row 550a is additionally input to buffers 500b, which delay the data by a time corresponding to the time required to shift data from row 550N to row SSOa. The data shifted out of row 550a can then be compared to the delayed original input data to determine if errors occurred during the data shifting and to identify potentially defective light modulation elements.

FIG. 7 illustrates an exemplary substrate exposure timing sequence using data shifting. FIG. 7 shows a series of liquid crystal (LC) settling intervals 702a - 702e (collectively 702) during which the LC material settles between exposures. At the end of each LC settling interval 702, the laser is flashed (represented by 710). Between consecutive LC settling intervals 702, there are transition time intervals tt₁ - tt₅. During each of the transition time intervals tt₁ - tt₅, data is moved between the memory elements within the SLM in preparation for the next exposure. The timing circuit 214 (shown in FIG. 2) can be utilized to apply the strobe signals to the strobe lines 520 (shown in FIG. 5) to drive the data propagation.

The electrical state of a common electrode signal 712 alternates between consecutive ones of time intervals tt₁ - tt₅. Transitions 708a-708e of the common electrode signal 712 occur during the time intervals tt₁ - tt₅ after the laser flashes, shown at 710. In FIG. 7, two exemplary pixel electrode signals 704 and 706 are shown, where pixel electrode signal 704 is illustrative of that of an ON liquid crystal element and pixel electrode signal 706 is illustrative of that of an OFF liquid crystal element. At each laser flash 602, the pixel electrode signal 704 on the pixel electrode has the same potential as the common electrode, and the pixel electrode signal 706 on the pixel electrode has the opposite potential as the common electrode. During the transition time intervals tt₁ - tt₅, data inversions are performed as data is shifting through the memory array to maintain DC balance of the liquid crystal elements. In one embodiment, the data is shifted between the memory elements of the light modulation elements during the transition time intervals tt₁ - tt₅ in about 60 microseconds, which allows 940 microseconds of a one millisecond duty cycle for the liquid crystal material to respond to the electric field applied between the pixel electrode and the common electrode. A twenty-nanosecond (20 ns) flash of the laser 710 occurs at the end of each of the LC settling intervals 702 after the liquid crystal material has transitioned. It should be understood that other timings can be established to increase or decrease the LC settling intervals 702 and data shifting rates based on the transition rate of the liquid crystal material and speed of the substrate moving with respect to the spatial light modulator.

The transition time intervals tt₁ - tt₅ between consecutive laser flashes 710 may be less than the time necessary to clock the data through the array of light modulation elements. In addition, with a shift register configuration of the light modulation elements, a defect at one point in the shift register chain caused by a defective light modulation element propagates from the defect point to the end of the chain, resulting in a large defective area in the array.

Therefore, in accordance with embodiments of the present invention, an improved strobe line configuration is shown in FIG. 8. The light modulation elements 310 are arranged in an array 300 having rows 550a, 550b, 550c, 550d...550N-1, 550N (collectively 550) and columns 560. In FIG. 8, the strobe lines 800a...800N (collectively referred to herein as 800) are electrically coupled to two adjacent rows 550 of light modulation elements 310 within the array 300. Thus, each strobe line 800 provides the same strobe signal 602 to two rows 550 of light modulation elements 310, and the data is shifted through the array 300 in an interleaving pattern between non-adjacent rows 550 of light modulation elements 310. By providing the same strobe signal 602 to two rows 550 of light modulation elements 310, the data is shifted through the array 300 two rows 550 at a time, reducing the number of clock cycles required to shift the data through the array 300 by 1/I, where I is the interleave factor and is equal to the number of rows connected to a single strobe line 800. It should be understood that although the strobe lines 800a...800N are shown coupled to the light modulation elements 310 with electrical conductors throughout the Figures, the strobe lines 800a...800N could alternatively be coupled to the light modulation elements 310 by intervening circuits, such as buffers, as described in co-pending and commonly assigned U.S. Application for Patent Serial No. (Attorney Docket No. 10030929).

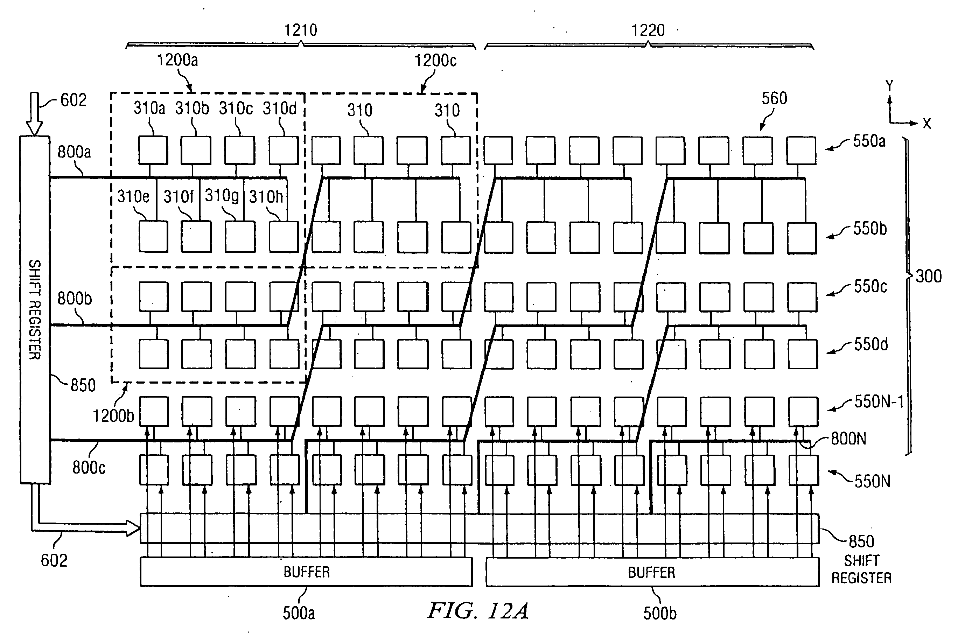

In other embodiments, each of the strobe lines 800 is electrically coupled to more than two rows 550 of light modulation elements 310. In another embodiment, the strobe lines 800 extend generally diagonally across the array 300 of light modulation element to alternately electrically connect to horizontally-adjacent and diagonally-adjacent light modulation elements 310 over two or more rows 550 to reduce the number of strobe lines 800. Such a configuration is shown in FIG. 12A, described in more detail below. In a further embodiment in which the data is shifted between columns 560 of the array 300, the strobe lines 800 are electrically coupled to two or more adjacent columns 560 of light modulation elements 310 within the array 300.

Each strobe line 800 is sequentially accessed using a shift register 850 that implements a digital delay line using a ripple clock to control the timing of the data shifting between the light modulation elements 310. For example, when a strobe signal 602 is sent from the timing circuit (214, shown in FIG. 2), the strobe signal 602 is input to the shift register 850 and is clocked through the shift register 850 to sequentially provide the strobe signal 602 to each of the strobe lines 800, starting with strobe line 800a to shift data out of the light modulation elements 310 in rows 550a and 550b of the array 300, continuing with strobe line 800b to shift data from the light modulation elements 310 in rows 550c and 550d to the light modulation elements 310 in rows 550a and 550b, respectively, and ending with strobe lines 800N to shift new data 222 into the light modulation elements 310 in rows 550N-1 and 550N of the array 300 from a data buffer 500 that stores the data 222 for rows 800N-1 and 800N.

In the example shown in FIG. 8, strobe line 800a provides strobe signal 602 to light modulation elements 310 in rows 550a and 550b to shift the data out of light modulation elements 310 in rows 550a and 550b. Strobe line 800b provides strobe signal 602 to light modulation elements 310 in rows 550c and 550d to shift data from the light modulation elements 310 in row 550c into the light modulation elements 310 in the corresponding columns 560 in row 550a and from the light modulation elements in row 550d into the light modulation elements in the corresponding columns 560 in row 550b. Strobe line 800N provides strobe signal 602 to light modulation elements 310 in rows 550N-1 and 550N to shift data from the light modulation elements 310 in row 550N-1 into the light modulation elements 310 in the corresponding columns 560 in row 550c and from the light modulation elements 310 in row 550N into the light modulation elements 310 in the corresponding columns 560 in row 550d. In addition, once the data is shifted out of the light modulation elements 310 in rows 550N-1 and 550N, new data 222 is shifted into the light modulation elements 310 in rows 550N-1 and 550N from the data buffer 500. With the data interleaving, the data buffer 500 is twice as wide to hold two rows of new data 222 at a time.

The data interleaving is illustrated in more detail in FIG. 9. Light modulation elements 310a-310h are shown arranged in a column 560. Strobe lines 800a-800d are connected to groups of two adjacent light modulation elements 310a-310h. For example, strobe line 800a is connected to provide the same strobe signal to light modulation elements 310a and 310b, strobe line 800b is connected to provide the same strobe signal to light modulation elements 310c and 310d, strobe line 800c is connected to provide the same strobe signal to light modulation elements 310e and 310f and strobe line 800d is connected to provide the same strobe signal to light modulation elements 310g and 310h.

When a strobe signal is provided along a strobe line (e.g., strobe line 800d) to two light modulation elements (e.g., 310g and 310h), the data stored in light modulation elements 310g and 310h is shifted up the column 560 in an interleaved pattern, such that data is shifted to non-adjacent light modulation elements. Thus, the data stored in light modulation element 310h is shifted up over input line 306a to light modulation element 310f and the data stored in light modulation element 310g is shifted up over input line 306b to light modulation element 310e. This pattern continues through the array of light modulation elements, shifting data two rows at a time over input lines 306a-306f between non-adjacent rows of light modulation elements. As a result, the effect of a defective light modulation element preventing propagation in the shift register chain is reduced. For example, if light modulation element 310h is defective, the defect is only propagated to light modulation elements 310f, 310d and 310b. The data in light modulation elements 310a, 310c, 310e and 310g is unaffected by defective light modulation element 310h.

FIG. 10 illustrates a logical interleaved association between pixel controllers 304a-304N (collectively 304) and memory elements 302a-302N (collectively 302) within respective light modulation elements of a spatial light modulator. The memory elements 302a-302N are shown divided into two groups 1000 and 1010. Each pixel controller 304 is associated with one of the memory elements 302 in either group 1000 or 1010 in an interleaving pattern. For example, pixel controller 304a is associated with memory element 302a in group 1000 and pixel controller 304b is associated with memory element 302b in group 1010. Data is consecutively shifted between memory elements 302 within the same group 1000 or 1010. Thus, data is consecutively shifted between memory elements 302a, 302c, 302e, 302g ... 302N-1 within group 1000, and data is consecutively shifted between memory elements 302b, 302d, 302f, 302h ... 302N within group 1010. Therefore, data is shifted through only a fraction of the memory elements 302, reducing the time required to shift the data through the memory elements 302 and reducing the effect of a propagation error between the memory elements 302.

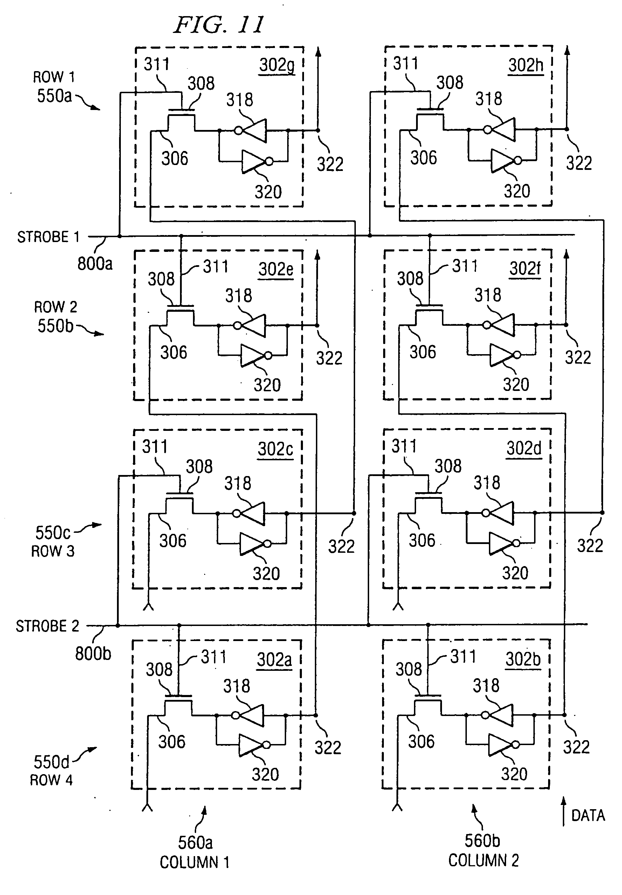

An exemplary circuit schematic for shifting data between memory elements 302 of non-adjacent light modulation elements in an interleaving pattern is shown in FIG. 11. Each memory element 302a-302h (collectively 302) includes an input line 306 and a forward access control element 308, as described above in connection with FIG. 3. In the example shown in FIG. 11, the forward access control element 308 is a transistor having a forward access strobe line 311 that is operable to control the state of the forward access control element 308 during a shift forward operation. Each memory element 302a-302h further includes a forward inverter 318 and a feedback inverter 320, as also described above in connection with FIG. 3.

The memory elements 302 are connected in an interleaving shift register configuration. In the interleaving shift register configuration, an output node 322 of a first memory element (e.g., memory element 302a) is connected to the input line 306 of a second, non-adjacent memory element (e.g., memory element 302e). Similarly, the output node 322 of a third memory element 302b is connected to the input line 306 of a fourth, non-adjacent memory element (e.g., memory element 302f). Memory elements 302a and 302e are in the same column 560a, but different, non-adjacent rows 550d and 550b, respectively. Likewise, memory elements 302b and 302f are in the same column 560a, but different, non-adjacent rows 550d and 550b, respectively.

Data is shifted from memory element 302a to memory element 302e and from memory element 302b to memory element 302f when a strobe signal is received on forward access strobe lines 311 of memory elements 302a and 302b via strobe line 800b that is connected between rows 550c and 550d. Data is also shifted from memory element 302c to memory element 302g and from memory element 302d to memory element 302h when the strobe signal is sent down strobe line 800b. Similarly, data is shifted out of memory elements 302e, 302f, 302g and 302h when a strobe signal is received on forward access strobe lines 311 of memory elements 302e, 302f, 302g and 302h via strobe line 800a that is connected between rows 550a and 550b.

FIG. 12A illustrates a shortened strobe line configuration for interleaving data between rows of light modulation elements in accordance with another embodiment of the present invention. In FIG. 12A, the strobe lines 800a, 800b, 800c...800N extend generally diagonally across the array 300 of light modulation elements 310. As used herein, the term "diagonal" means passing through at least two non-orthogonal light modulation elements 310, where "non-orthogonal" means positioned in different rows and different columns of the array 300. Those of the light modulation elements 310 coupled to each of the strobe lines 800 constitute a set of the light modulation elements 310. In one embodiment, as shown in FIG. 12A, each strobe line 800 is electrically coupled to at least a respective first group of light modulation elements (e.g., strobe line 800a is connected to group 1200a), in which the first group includes a portion of two adjacent rows 550 (e.g., rows 550a and 550b) of light modulation elements 310. Thus, each strobe line 800 is electrically coupled to a set of light modulation elements 310 including row-adjacent (in the y-direction) and column-adjacent (in the x-direction) ones of the light modulation elements 310. In other embodiments, each strobe line 800 is electrically connected to both a respective first group (e.g., strobe line 800b is connected to group 1200b) and a respective second group (e.g., group 1200c), in which the first group and second group are positioned diagonally adjacent one another within the array 300 of light modulation elements 310. The diagonally-extending strobe line configuration in FIG. 12A reduces the length of individual strobe lines 800, which reduces clock skew and allows the operational frequency of the spatial light modulator to be increased. In addition, the diagonally-extending strobe lines 800 result in strobe lines 800 extending across only a portion of the total width of the array 300, which limits the extent of damage resulting from a failure in strobe line 800 to a smaller portion of the array 300.

In the example shown in FIG. 12A, strobe line 800a provides a strobe signal to light modulation elements 310a-310h that are orthogonally adjacent within group 1200a to shift the data out of light modulation elements 310a-310h within group 1200a. Light modulation elements 310a-310d in row 550a are horizontally adjacent, i.e., adjacent in the x-direction, and light modulation elements 310e-310h in row 550b are horizontally adjacent. In addition, light modulation elements 310a-310d are vertically adjacent, i.e., adjacent in the y-direction, to light modulation elements 310e-310h. Likewise, strobe line 800b provides a strobe signal to orthogonally adjacent light modulation elements 310 within group 1200b and to orthogonally adjacent light modulation elements 310 within group 1200c. Groups 1200b and 1200c are positioned diagonally adjacent in the array 300. In addition, groups 1200b and 1200c are positioned orthogonally adjacent group 1200a Specifically, group 1200b is vertically adjacent group 1200a and group 1200c is horizontally adjacent group 1200a. Therefore, a strobe signal propagating down strobe line 800b causes data to be shifted out of the light modulation elements 310 within group 1200b and into the light modulation elements 310 in the corresponding column 560 within group 1200a in an interleaved pattern, and causes data to be shifted out of the light modulation elements 310 within group 1200c.

As described above in connection with FIG. 8, each strobe line 800 is sequentially accessed using a shift register 850 that implements a digital delay line using a ripple clock to control the timing of the data shifting between the light modulation elements 310. For example, when a strobe signal 602 is sent from the timing circuit (214, shown in FIG. 2), the strobe signal 602 is input to the shift register 850 and is clocked through the shift register 850 along the rows 550 in the y-direction and columns 560 in the x-direction to sequentially provide the strobe signal 602 to each of the strobe lines 800, starting with strobe line 800a and ending with strobe line 800N. Data for a first section 1210 of the array 300 is loaded into the light modulation elements 310 in rows 550N-1 and 550N within the first section 1210 in parallel from buffer 500a, while data for a second section 1220 of the array 300 is loaded into the light modulation elements 310 in rows 550N-1 and 550N within the second section 1220 in parallel from buffer 500b. It should be understood that multiple buffers 500 can be used to store and input data into the array. For example, in one embodiment, 128 first-in-first-out (FIFO) buffers 500 are used, and each buffer is 256 kbytes wide. It should further be understood that each FIFO 500 should be deep enough to hold at least two data segments, depending on the interleave factor, to allow variable scanning velocities.

In another embodiment in which the data is shifted between the columns 560 of the array 300, the strobe lines 800 are electrically connected to groups of portions of vertically adjacent columns 560 of light modulation elements 310 diagonally positioned relative to one another. In a further embodiment, the strobe lines 800 can continue in the same pattern across the entire area of the array 300. In other embodiments, the strobe lines 800 can be arranged in a first pattern across a first portion of the array 300 and in a second pattern across a second portion of the array. For example, the strobe lines 800 can be arranged in two patterns that mirror one another, and the mirroring strobe lines 800 in each portion of the array 300 can be accessed simultaneously to increase the operational frequency of the strobe lines 800 of spatial light modulator, as described in co-pending and commonly assigned U.S. Application for Patent Serial No. (Attorney Docket No. 10030517), which is incorporated by reference herein.

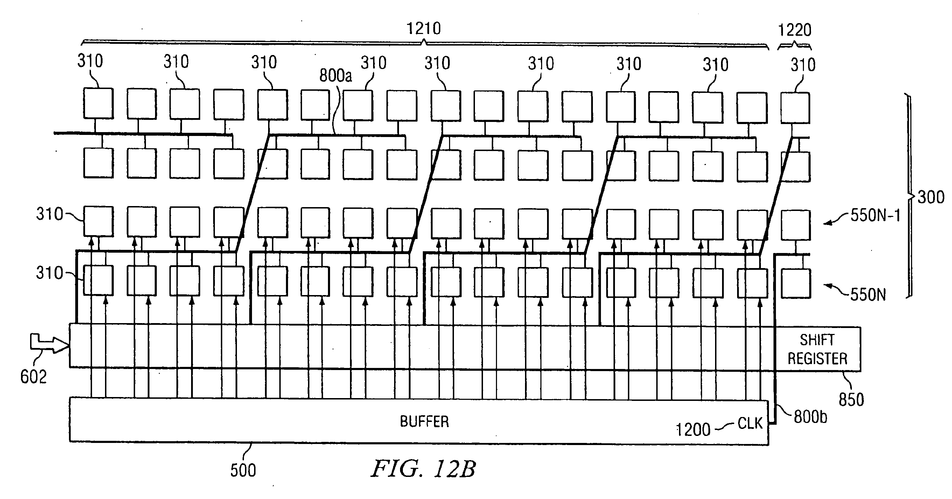

FIG. 12B illustrates an exemplary clocking method for clocking the buffers 500 in the strobe line configuration shown in FIG. 12A. Each buffer 500 stores data for a section of the array 300 of light modulation elements 310. To ensure that the data is preserved as it is shifted through the light modulation elements 310 and to improve operational efficiency of the spatial light modulator, each buffer 500 shifts data into the array 300 after the strobe signal passes the light modulation elements 310 associated with the buffer 500. In the example shown in FIG. 12B, buffer 500 loads data into light modulation elements 310 in rows 550N-1 and 550N within section 1210 of the array 300. As the strobe signal 602 propagates through all of the strobe lines 800a connected to the light modulation elements 310 within the first section 1210, the data is shifted out of the light modulation elements 310 in rows 550N-1 and 550N within section 1210, enabling the light modulation elements 310 in rows 550N-1 and 550N within section 1210 to receive new data from the buffer 500. When the strobe signal 602 reaches the first strobe line 800b within a second section 1220 of light modulation elements 310, adjacent to the first section 1210 of light modulation elements 310, the strobe signal 602 is provided to the buffer 500 for the first section 1210 of light modulation elements 310 to clock 1230 the buffer 500 for the first section 1210 of light modulation elements 310, causing the buffer 500 to advance (or load data) into the light modulation elements 310 in rows 550N-1 and 550N in the first section 1210.

Each strobe signal 602 propagating along the shift register 850 is separated by the width of the buffer 500 from other strobe signals 602 to prevent advancement of the buffer 500 during data shifting out of the light modulation elements 310 associated with the buffer 500. For example, for a 256 wide FIFO 500, there are 32 strobe lines per FIFO 500. Therefore, the strobe signals 602 are spaced at least 33 clock cycles apart. As an example, a first strobe signal 602 is sent from the timing circuit (216, shown in FIG. 2) at time to, and a second strobe signal 602 is sent from the timing circuit at time t₃₃ to allow the first strobe signal 602 to propagate through all of the strobe lines 800a associated with a buffer 500 and clock the buffer 500 to load new data into the light modulation elements 310 in rows 550N-1 and 550N within the first section 1210 before the second strobe signal 602 is received by the first strobe line 800a associated with the buffer 500.

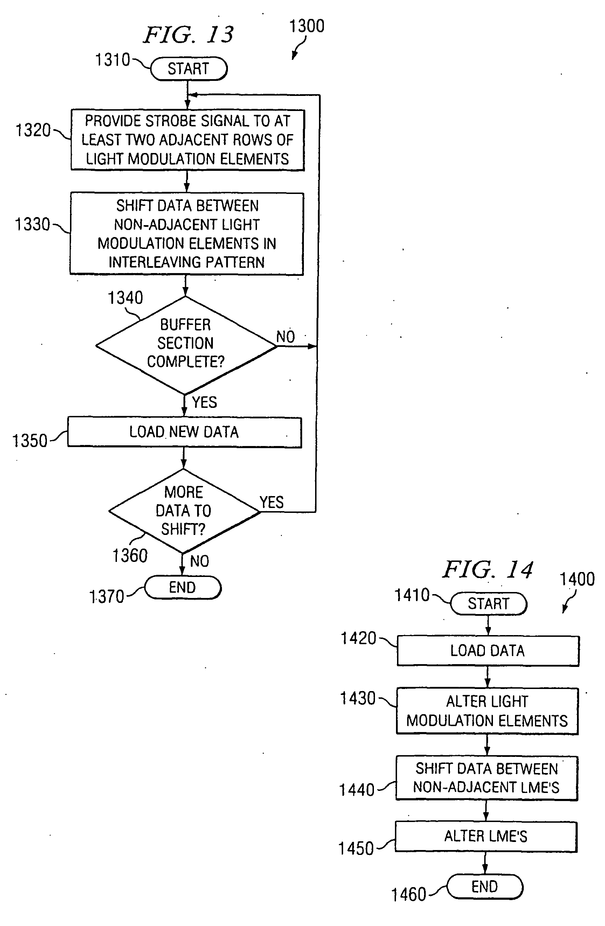

FIG. 13 is a flow chart illustrating an exemplary process 1300 to provide strobe signals to light modulation elements within a spatial light modulator to shift data between light modulation elements. The process starts at block 1310. At block 1320, a strobe signal is applied to a strobe line coupled to at least a portion of at least two adjacent rows of light modulation elements to trigger the shifting of data between non-adjacent ones of the light modulation elements in an interleaving pattern at block 1330. At block 1340, if the strobe signal does not complete the data shifting for at least one section of light modulation elements associated with at least one buffer, the strobe signal propagates to the next strobe line in the shift register chain at block 1320.

However, if the strobe signal does complete the data shifting for at least one section of light modulation elements at block 1340, new data is loaded into the light modulation elements from the buffer(s) associated with the completed section(s) at block 1350. For example, if the strobe line is the first strobe line in a second section of light modulation elements, indicating the completion of data shifting in a first section of light modulation elements, the buffer associated with the first section of light modulation elements is clocked to load data into the light modulation elements within the first section. As another example, if the strobe line is the last strobe line in the shift register chain, indicating the completion of data shifting throughout the array of light modulation elements, the buffer(s) are clocked to load data into their respective sections of the light modulation elements.

At block 1360, if the data shifting throughout the array is complete, the process ends at block 1370. However, if there still remains data to be shifted in the array, at block 1320, the strobe signal propagates to the next strobe line in the shift register chain with the next clock cycle to provide the strobe signal to the light modulation elements in at least another portion of at least two adjacent rows of light modulation elements to trigger the shifting of data between non-adjacent ones of the light modulation elements in an interleaving pattern.

FIG. 14 is a flow chart illustrating an exemplary process 1400 for shifting data within a spatial light modulator to dynamically photolithographically transfer an image onto a substrate. The photolithography process starts at block 1410. At block 1420, data representing an image is loaded into light modulation elements within a spatial light modulator. At block 1430, the light modulation elements are altered in response to the data loaded thereinto. The altered light modulation elements are illuminated to direct an illumination pattern onto the substrate. At block 1440, the data is shifted between non-adjacent light modulation elements. For example, strobe signals can be applied to strobe lines that are electrically coupled to respective portions of at least two respective adjacent rows or columns of light modulation elements to cause the data to be shifted bi-directionally between non-adjacent rows and/or columns of an array of light modulation elements in an interleaving pattern. At block 1450, the light modulation elements are altered again in response to the data moved between the light modulation elements. The process ends at block 1460.

The innovative concepts described in the present application can be modified and varied over a wide rage of applications. Accordingly, the scope of patented subject matter should not be limited to any of the specific exemplary teachings discussed, but is instead defined by the following claims.

## Claims

1. An electronic circuit having circuit elements (310) arranged in an array (300) of rows (550) and columns (560), said circuit elements (310) being alterable in response to data (222) stored therein and configured to shift data (222) therebetween, said electronic circuit being **characterized by**:
a strobe line (800) electrically coupled to ones of said circuit elements (310) constituting a set to provide thereto a strobe signal (602) to cause said ones of said circuit elements (310) in said set to shift data (222) to non-adjacent ones of said circuit elements (310) outside said set in an interleaving pattern, said set including row-adj acent and column-adjacent ones of said circuit elements (310).

2. The electronic circuit of Claim 1, wherein said strobe line (800) is electrically coupled to ones of said circuit elements (310) located in at least a portion of at least two adjacent rows (550) of the array (300).

3. The electronic circuit of Claim 2, wherein:
said strobe line (800) is electrically coupled to ones of said circuit elements (310) located in a first pair of adjacent rows (550) of the array (300) to provide a first strobe signal (602) to said ones of said circuit elements (310) located in the first pair of adjacent rows (550); and
said electronic circuit additionally comprises an additional strobe line (800) electrically coupled to ones of said circuit elements (310) located in a second pair of adjacent rows (550) of the array (300) to provide a second strobe signal (602) to said ones of said circuit elements (310) located in the second pair of adjacent rows (550), said first strobe signal (602) being operable to shift data (222) from said ones of said circuit elements (310) in the first pair of adjacent rows (550) to said ones of said circuit elements (310) in the second pair of adjacent rows (550).

4. The electronic circuit of Claim 1, wherein said strobe line (800) is electrically coupled to ones of said circuit elements (310) located in at least a portion of at least two adjacent columns (560) of the array (300).

5. The electronic circuit of Claim 1, wherein said strobe line (800) is electrically coupled to at least two groups of orthogonally-adjacent ones of said circuit elements (310), said at least two groups being positioned diagonally in the array (300) with respect to one another.

6. The electronic circuit of any of Claims 1 to 5, further comprising: a buffer (500) connected to at least one end of the array (300) to load the data (222) into ones of said circuit elements (310), said buffer (500) comprising buffer elements (500a and 500b), each of said buffer elements (500a and 500b) loading data (222) into a respective portion (1210 and 1220) of the array (300), said strobe line (800b) being within a second portion (1220) of the array (300) and being connected to clock one of said buffer elements (500a) associated with a first portion (1210) of the array (300) to load data (222) into the first portion (1210) of the array (300).

7. A method for performing photolithography, said method comprising:
loading (1420) data representing an image into light modulation elements;
altering (1430) ones of the light modulation elements in response to the data loaded thereinto to transfer an instance of the image onto a substrate;
shifting (1440) the data between non-adjacent ones of the light modulation elements in an interleaving pattern; and
altering (1450) ones of the light modulation elements in response to the data shifted thereinto to transfer another instance of the image onto the substrate.

8. The method of Claim 7, wherein said shifting further comprises:
applying (1320) strobe signals to strobe lines electrically coupled to respective ones of said light modulation elements to cause the data to be shifted (1330) between the non-adjacent ones of the light modulation elements.

9. The method of Claim 8, further comprising: providing the light modulation elements arranged in an array of rows and columns; and wherein said shifting further comprises:
applying the strobe signals to respective sets of the light modulation elements, at least one of the sets comprising ones of the light modulation elements in at least a portion of at least two adjacent rows; and
shifting the data between the light modulation elements in non-adjacent rows.

10. The method of Claim 8, wherein said shifting further comprises:
applying the strobe signals to respective sets of the light modulation elements,, at least one of the sets comprising ones of the light modulation elements in at least a portion of at least two adjacent columns; and
shifting the data between the light modulation elements in non-adjacent columns.
